# EUROPÄISCHE PATENTSCHRIFT

(11) **EP 1 412 973 B1**
(45) Veröffentlichungstag und Bekanntmachung des Hinweises auf die Patenterteilung: **27.04.2005**
(21) Anmeldenummer: 02760214.3
(22) Anmeldetag: 02.07.2002
(51) Int. Cl.: H01L 21/336, H01L 29/78

(54) **HALBLEITERSTRUKTUR MIT FELDPLATTE**
SEMICONDUCTOR STRUCTURE COMPRISING A FIELD PLATE
STRUCTURE A SEMI-CONDUCTEURS DOTEE D'UNE PLAQUE DE CHAMP

(30) Priorität: 31.07.2001 DE 10137343
(43) Veröffentlichungstag der Anmeldung: 28.04.2004
(73) Patentinhaber: Infineon Technologies AG, 81669 München (DE)
(72) Erfinder: KRUMBEIN, Ulrich, 83026 Rosenheim (DE); TADDIKEN, Hans, 81737 München (DE)
(74) Vertreter: Zimmermann, Tankred Klaus
(86) Internationale Anmeldenummer: PCT/EP2002/007297
(87) Internationale Veröffentlichungsnummer: WO 2003/012854

(56) Entgegenhaltungen:
- US-A- 4 172 260
- US-A- 4 288 806
- US-A- 4 614 959
- US-A- 6 153 916

## Beschreibung

Die vorliegende Erfindung bezieht sich allgemein auf eine Halbleiterstruktur und insbesondere auf eine Halbleiterstruktur, welche einen Sourcebereich, einen lateral diffundierten Kanalbereich sowie einen Drainbereich umfasst, bei der drainseitig eine Feldplatte angeordnet ist.

Im Stand der Technik sind Halbleiterstrukturen mit lateralen Kanalbereichen bekannt, wie z. B. LDMOS-Transistoren (LDMOS = Lateral Diffused Metal Oxid Semiconductor = Metall-Oxid-Halbleiter mit lateralem Diffusionsgebiet). Solche LDMOS-Transistoren beinhalten drainseitig einen langen Drainbereich, der auch als LDD bezeichnet wird (LDD = Lightly Doped Drain = leicht dotierter Drainbereich). Der Nachteil solcher Strukturen besteht darin, dass bei höheren Drain-Spannungen und Drain-Strömen eine vermehrte Stoßionisation im Bereich des Anschlusses der LDD an die Drain-Kontakt-Implantation auftritt. Die so erzeugten Elektron-Loch-Paare bewirken einen zusätzlichen Strom, der nicht durch den Kanal des Transistors fließt. Dieser zusätzliche, nicht durch den Kanal des Transistors fließende Strom ist unerwünscht und soll vermieden werden.

Eine Lösung dieser Problematik, wie sie aus dem Stand der Technik bekannt ist, besteht darin ein zusätzliches Implantationsgebiet zwischen dem leicht dotierten Drainbereich und der Drain-Implantation vorzusehen, wobei eine Dotierungskonzentration des zusätzlichen Implantationsgebiets zwischen einer Dotierungskonzentration des leicht dotierten Drainbereichs und der Drain-Implantation liegt. Hierdurch wird der Konzentrationsgradient verringert, was die Stoßionisation reduziert.

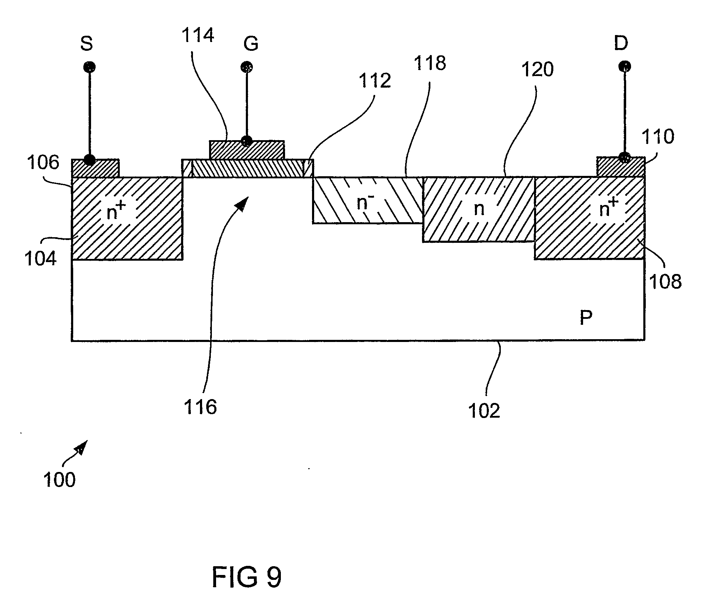

Anhand der Fig. 9 wird ein bekannter LDMOS-Transistor gemäß dem Stand der Technik näher erläutert. Die Halbleiterstruktur in Fig. 9 ist in ihrer Gesamtheit mit dem Bezugszeichen 100 versehen und umfasst ein Substrat 102 aus einem p-Material, in dem die Strukturen des LDMOS-Transistors erzeugt sind.

In dem Substrat 102 ist ein Sourcebereich 104 mit einer hohen n⁺-Dotierung gebildet. Auf dem Sourcebereich 104 ist ein Sourcekontakt 106 aus einem Metall angeordnet, der mit einem Sourceanschluss S verbunden ist. In dem Substrat 102 ist ferner ein Drainbereich 108 mit einer hohen n⁺-Dotierung gebildet. Ein Drainkontakt 110 ist auf dem Drainbereich angeordnet und mit einem Drainanschluss D verbunden. Auf dem Substrat 102 ist ein Gateoxid 112 angeordnet, auf dem ein Gatekontakt 114 aus Metall angeordnet ist, der mit einem Gateanschluss G verbunden ist. Unter dem Gateoxid 112 ist der Kanalbereich 116 der LDMOS-Transistorstruktur festgelegt. Zwischen dem Kanalbereich 116 und dem Drainbereich 108 ist ein leicht dotierter Drainbereich (LDD) 118 mit einer niedrigen n⁻-Dotierung gebildet. Zwischen dem leicht dotierten Drainbereich 118 und dem Drainbereich 108 ist ein Zwischenbereich mit einer n-Dotierung gebildet, die zwischen der n⁺-Dotierung des Drainbereichs 108 und der n⁻-Dotierung des leicht dotierten Drainbereichs 118 liegt. Die Anordnung des Zwischenbereichs 120 führt zu der Verringerung des Dotierungskonzentrationsgradienten, wodurch eine Stoßionisation im Bereich der eigentlichen Drain-Implantation, dem Drainbereich 108, reduziert wird. Anordnungen, wie sie anhand der Fig. 9 beschrieben wurden, sind beispielsweise aus der US-A-4,172,260 und aus der US-A-6,020,611 bekannt. Aus US-4 288 806 ist ein Hochspannungs-MOS-Transistor bekannt, mit einer Feldplatte, um die Durchbruchspannung im Drainbereich zu erhöhen.

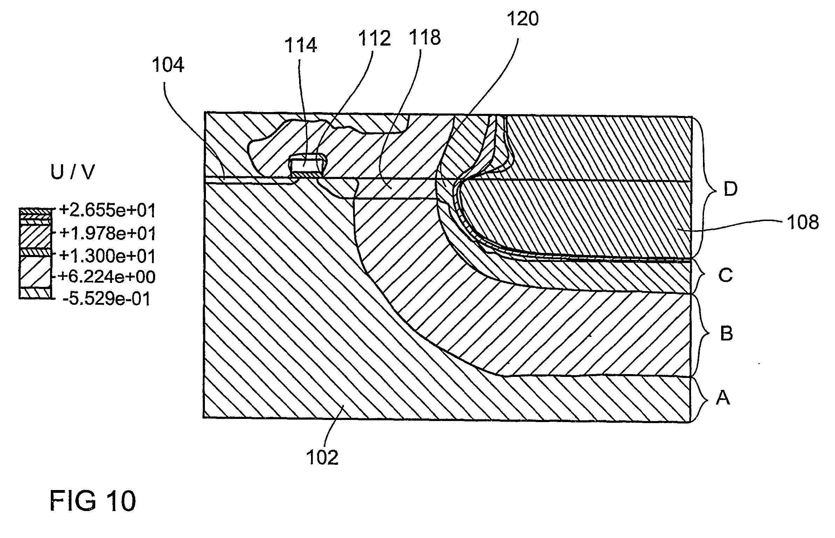

In Fig. 10 ist schematisch eine Spannungsverteilung zwischen dem Gatebereich und dem Drainbereich des LDMOS-Transistors aus Fig. 9 dargestellt. Bei dem in Fig. 10 gezeigten Beispiel liegt am Gateanschluss G eine Spannung U_{Gate} von 16 V und am Drainanschluss D eine Drainspannung U_{Drain} von 26 V an. In einem ersten Bereich A, der sich im wesentlichen im Substratbereich 102 bis unter den Gatebereich 114 und den Sourcebereich 104 erstreckt, liegt das Potenzial bei etwa -0,55 V. Im Bereich B, der an den Bereich A angrenzt, liegt das Potenzial zwischen etwa 6,224 V und etwa 13 V. Im Bereich C, der sich ausgehend von einem Bereich unterhalb des Drainbereichs 108 über Randbereiche des Zwischenbereichs 102 und der LDD 118 über die Bereiche 118 und 120 erstreckt, liegt die Spannung im Bereich von etwa 13 V bis etwa 20 V. Im Bereich D, der den Drainbereich 108 sowie einen Bereich oberhalb desselben und den größten Teil des Zwischenbereichs 120 sowie der darüber liegenden Region umfasst, liegt die Spannung im Bereich von etwa 20 V bis etwa 26 V.

Aus Fig. 10 ist der Bereich der erhöhten Spannung oberhalb des Drainbereichs 108 und des Zwischenbereichs 120 sowie im Grenzbereich der zwei Bereich zu erkennen. Aufgrund des dort vorherrschenden hohen Gradienten des elektrischen Potenzials findet, trotz der erreichten Reduzierung des Dotierungskonzentrationsgradienten, immer noch eine signifikante Stoßionisation statt, die einen entsprechenden Strom erzeugt.

Ausgehend von diesem Stand der Technik liegt der vorliegenden Erfindung die Aufgabe zugrunde, eine verbesserte Halbleiter-Struktur zu schaffen, die eine reduzierte Stoßionisation im Betrieb aufweist.

Diese Aufgabe wird durch eine Halbleiter-Struktur nach Anspruch 1 gelöst.

Der vorliegenden Erfindung liegt die Erkenntnis zugrunde, dass eine weitergehende Reduktion der Stoßionisation dadurch erreicht werden kann, dass eine Feldplatte im Drainbereich einer Halbleiterstruktur, wie z. B. ein LDMOS-Transistors eingesetzt wird, wobei die Feldplatte gemäß einem bevorzugten Ausführungsbeispiel mit einer vorbestimmten Spannung beaufschlagt wird, um die Parameter der Transistorstruktur zu beeinflussen.

Gemäß einem Ausführungsbeispiel der vorliegenden Erfindung ist die Feldplatte direkt auf dem Substrat angeordnet, um einen hochohmigen Kontakt oder eine Schottky-Diode zum Halbleitermaterial des Substrats bzw. des darunter liegenden Drainbereichs zu bilden. Bei einem anderen Ausführungsbeispiel ist die Feldplatte auf einer isolierenden Schicht, z. B. auf einer Oxidschicht, angeordnet, die ihrerseits auf dem Substrat angeordnet ist, so dass die Feldplatte durch das Oxid von dem Substrat getrennt ist.

Gemäß einem weiteren Ausführungsbeispiel ist die Feldplatte mit einer Spannung beaufschlagbar, die im Bereich von 20 V bis 80 V liegen kann, wobei die Spannung die Drainspannung nicht überschreiten darf, um die Durchbruchspannung des Drainbereichs zu erhöhen.

Gemäß einem bevorzugten Ausführungsbeispiel der vorliegenden Erfindung umfasst der erste Drainabschnitt einen Zwischenbereich, der eine dritte Dotierungskonzentration aufweist, die höher ist als die zweite Dotierungskonzentration und die niedriger ist als die erste Dotierungskonzentration. Der Zwischenbereich ist benachbart zu dem zweiten Drainabschnitt angeordnet.

Bevorzugte Weiterbildungen der vorliegenden Erfindung sind in den Unteransprüchen definiert.

Nachfolgend werden anhand der beiliegenden Zeichnungen bevorzugte Ausführungsbeispiele der vorliegenden Erfindung näher erläutert. Es zeigen:
Fig. 1 eine schematische Darstellung eine LDMOS-Transistors mit einer Feldplatte gemäß einem ersten Ausführungsbeispiel der vorliegenden Erfindung;
Fig. 2 eine schematisch Darstellung eines LDMOS-Transistors mit einer Feldplatte gemäß einem zweiten Ausführungsbeispiel der vorliegenden Erfindung;
Fig. 3 eine schematische Darstellung der Dotierungsverteilung zwischen dem Gatebereich und dem Drainbereich des LDMOS-Transistors aus Fig. 2;
Fig. 4 eine schematische Darstellung eines LDMOS-Transistors mit einer Feldplatte gemäß einem dritten Ausführungsbeispiel der vorliegenden Erfindung;
Fig. 5 eine schematische Darstellung der Dotierungsverteilung zwischen dem Gatebereich und dem Drainbereich des LDMOS-Transistors aus Fig. 4;
Fig. 6 eine schematische Darstellung der Spannungsverteilung zwischen dem Gatebereich und dem Drainbereich des LDMOS-Transistors aus Fig. 5;
Fig. 7 einen Graphen, der den Verlauf des Drainstroms und den Anteil der Stoßionisation am Drainstrom mit und ohne Feldplatte über der Gatespannung darstellt;
Fig. 8 einen Graphen, der den Einfluss der Feldplatte auf die Durchbruchspannung darstellt;
Fig. 9 einen LDMOS-Transistor gemäß dem Stand der Technik; und
Fig. 10 eine schematische Darstellung der Spannungsverteilung zwischen dem Gatebereich und dem Drainbereich des LDMOS-Transistors aus Fig. 9.

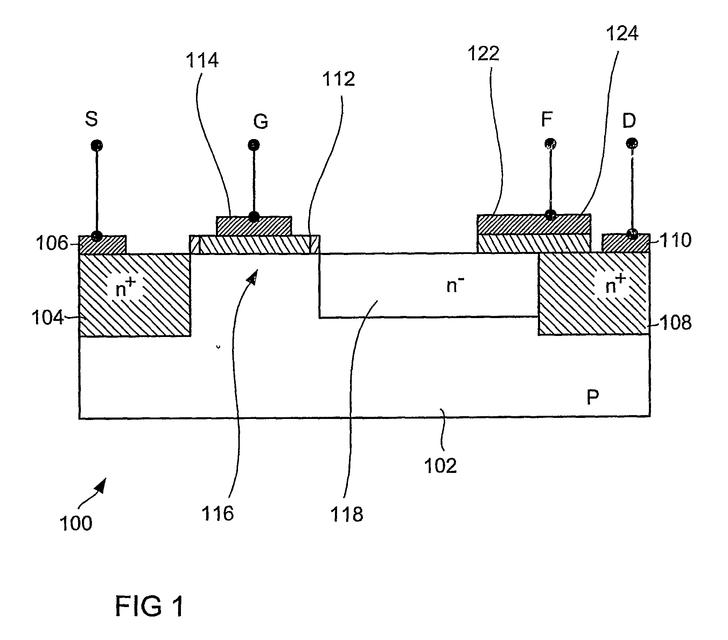

Anhand der Fig. 1 wird nachfolgend ein erstes Ausführungsbeispiel der vorliegenden Erfindung näher erläutert. Hinsichtlich der nachfolgenden Beschreibung der bevorzugten Ausführungsbeispiele wird darauf hingewiesen, dass in den unterschiedlichen Figuren ähnliche, gleiche Elemente oder gleich wirkende Elemente mit den gleichen Bezugszeichen versehen werden.

In Fig. 1 ist ein erstes Ausführungsbeispiel der erfindungsgemäßen Halbleiterstruktur dargestellt, wobei Elemente, die bereits anhand der Fig. 9 beschrieben wurden, mit gleichen Bezugszeichen versehen sind, und nicht erneut beschrieben werden.

Im Vergleich zu der in Fig. 9 gezeigten Halbleiterstruktur umfasst die in Fig. 1 gezeigte Halbleiterstruktur 100 keinen Zwischenbereich 120. Bei dem in Fig. 1 dargestellten Ausführungsbeispiel ist nur die LDD 118 vorgesehen, die sich zwischen dem hoch dotierten Drainbereich 108 und dem Kanalbereich 116 erstreckt. Die Halbleiterstruktur 100 umfasst gemäß der vorliegenden Erfindung zusätzlich eine Feldplatte 122, die über dem Übergang zwischen der LDD 118 und dem Bereich 108 angeordnet ist. Zwischen der Feldplatte 122 und dem Siliziumsubstrat 102 ist eine isolierende Schicht 124, z. B. eine Oxidschicht angeordnet. Bei dem dargestellten Ausführungsbeispiel ist die Feldplatte 122 mit einem Feldplattenanschluss F verbunden. Alternativ kann die Feldplatte auch direkt auf dem Substrat 102 angeordnet sein, und wirkt dann als hochohmiger Kontakt oder als Schottky-Diode.

Die Feldplatte 122 ist aus einem leitfähigen Material gebildet. Die Feldplatte ist mit einer elektrischen Spannung beaufschlagbar und bewirkt, abhängig von der Lage der Festplatte und der angelegten elektrischen Spannung eine entsprechende Veränderung der elektrischen Feldlinien, so dass sich der Spannungsgradient und somit die Stoßionisation verringert. Neben der Reduktion der Stoßionisation aufgrund der Verwendung der Feldplatte 122 hat diese weitere vorteilhafte Auswirkungen auf die Betriebscharakteristika des in Fig. 1 dargestellten Transistors. Zum einen lässt sich der maximale Strom in einem oberen Kennlinienbereich des Transistors erhöhen, ein Abknicken der Kennlinie erfolgt erst bei höheren Gatespannungen. Ein weiterer Vorteil der Verwendung der Feldplatte besteht darin, dass diese bei geeigneter Wahl der angelegten Spannung eine Erhöhung der Durchbruchspannung ermöglicht.

Die oben beschriebenen Vorteile werden nachfolgend anhand weiterer Ausführungsbeispiele und weiterer Figuren näher erläutert.

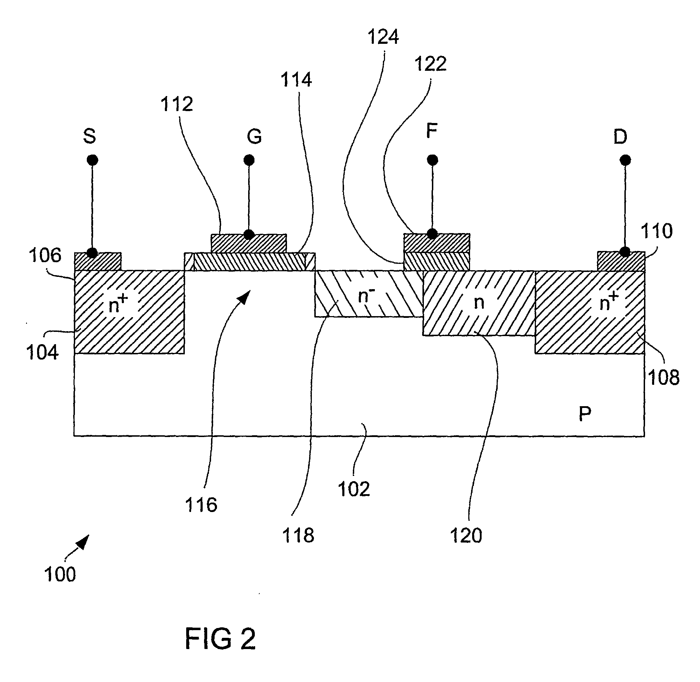

Anhand der Fig. 2 wird nachfolgend ein weiteres bevorzugtes Ausführungsbeispiel der vorliegenden Erfindung näher erläutert. Bei der in Fig. 2 dargestellten Halbleiterstruktur handelt es sich um einen LDMOS-Transistor, der eine Struktur aufweist, die ähnlich zu der in Fig. 9 ist. Zusätzlich weist die Struktur die Feldplatte 122 auf, die bei dem in Fig. 2 gezeigten Ausführungsbeispiel bezüglich des ersten Drainabschnitts 108 zurückgesetzt ist und in einem Bereich oberhalb der LDD 118 angeordnet ist und sich ferner über den Zwischenabschnitt 120 erstreckt.

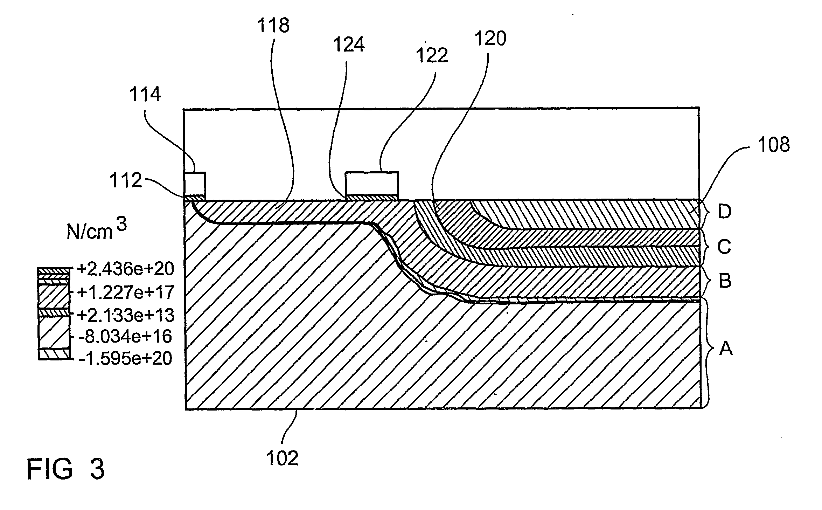

In Fig. 3 ist schematisch der Dotierungsverlauf zwischen dem Gatebereich und dem Drainbereich des LDMOS-Transistors aus Fig. 2 dargestellt. Im Bereich A liegt die Dotierungskonzentration des p-Materials bei etwa 8 x 10¹⁶ /cm³. Im Bereich B liegt die n-Dotierungskonzentration zwischen 2,1 x 10¹³ /cm³ bis 1,2 x 10¹⁷ /cm³. Im Bereich C liegt die Dotierungskonzentration im Bereich von 1,3 x 10¹⁷ /cm³. Im Bereich D liegt die p-Dotierung bei etwa 2,4 x 10²⁰ /cm³. Der Bereich A umfasst das p-Substrat 102, also die außerhalb der n-dotierten Bereiche liegenden Abschnitte des p-Substrats. Der Bereich B in Fig. 3 erstreckt sich von dem Bereich unterhalb der Drain 108 in die LDD 118 und in diesem Bereich liegt die verglichen mit den Dotierungskonzentrationen in dem Zwischenabschnitt 120 und in dem ersten Drainabschnitt 108 niedrigste Dotierungskonzentration vor. Der Bereich C erstreckt sich unterhalb der Drain 108 in den Zwischenbereich 120 und weist eine Dotierungskonzentration auf, die größer ist als im Bereich 118, jedoch kleiner als im Drainbereich 108. Der Drainbereich 108 ist im Bereich D am stärksten dotiert.

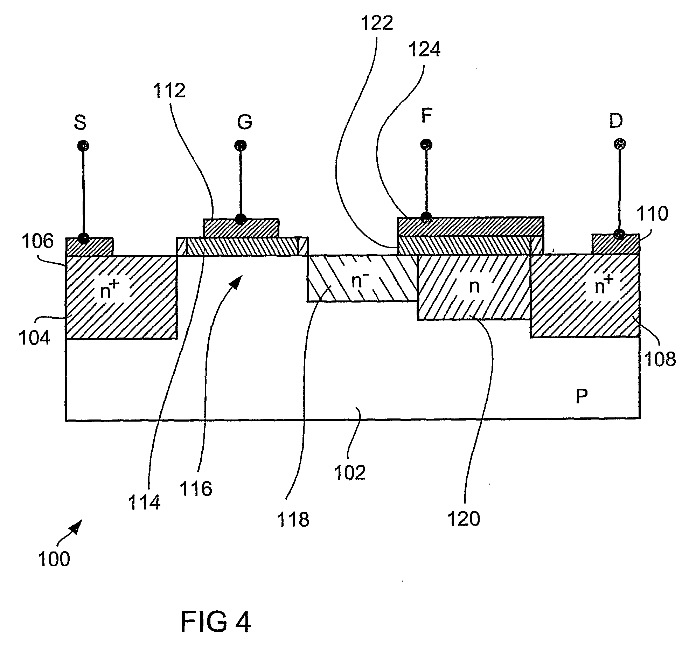

In Fig. 4 ist ein drittes Ausführungsbeispiel der erfindungsgemäße Feldplatte in Verbindung mit einem LDMOS-Transistor dargestellt. Verglichen mit dem anhand der Fig. 2 beschriebenen Ausführungsbeispiel ist dort die Feldplatte 122 bezüglich des ersten Drainabschnitts 108 nicht zurückgesetzt, sondern erstreckt sich ausgehend von dem Abschnitt 118 bis über den Drainbereich 108.

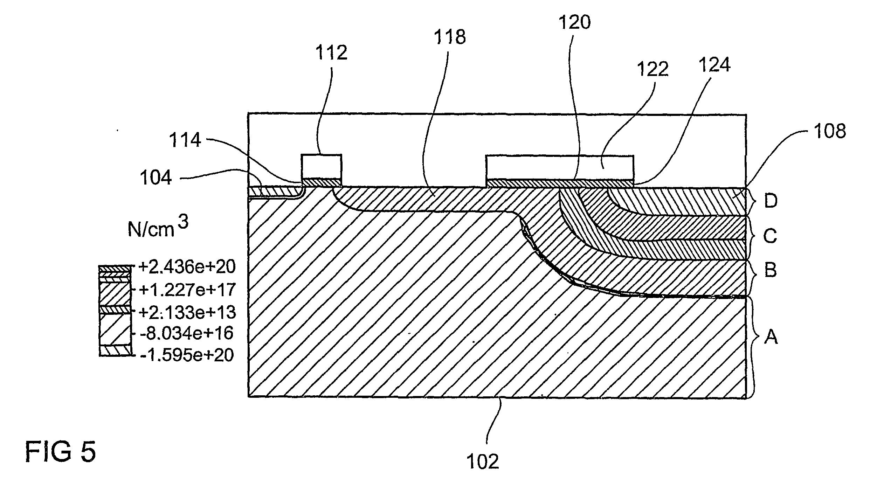

In Fig. 5 ist die Dotierungsverteilung zwischen dem Sourcebereich 104 und dem Drainbereich 108 gezeigt. Im Sourcebereich beträgt die n-Dotierungskonzentration etwa 2,4 x 10²⁰ /cm³. Im Bereich A, der sich unter dem Drainbereich 108 in dem Substrat 102 bis unter den Abschnitt 118, unter den Gatebereich 112 und unter den Sourcebereich 104 erstreckt, beträgt die p-Dotierungskonzentration etwa 8 x 10¹⁶ /cm³. Im Bereich B, der sich ausgehend von unterhalb des Drainbereichs 108 in den Abschnitt 118 erstreckt, liegt die n-Dotierungskonzentration zwischen 2 x 10¹³ /cm³ und 1,3 x 10¹⁷ /cm³. Im Bereich C, der sich unterhalb des Drainbereichs 108 zu dem Zwischenbereich 120 erstreckt, liegt die n-Dotierungskonzentration in der Größenordnung von etwa 1,3 x 10¹⁷ /cm³ bis 2 x 10²⁰ /cm³. Im Bereich D, der im wesentlichen dem unter der Drain 108 liegenden Bereich entspricht, liegt die Dotierungskonzentration bei etwa 2,5 x 10²⁰ /cm³.

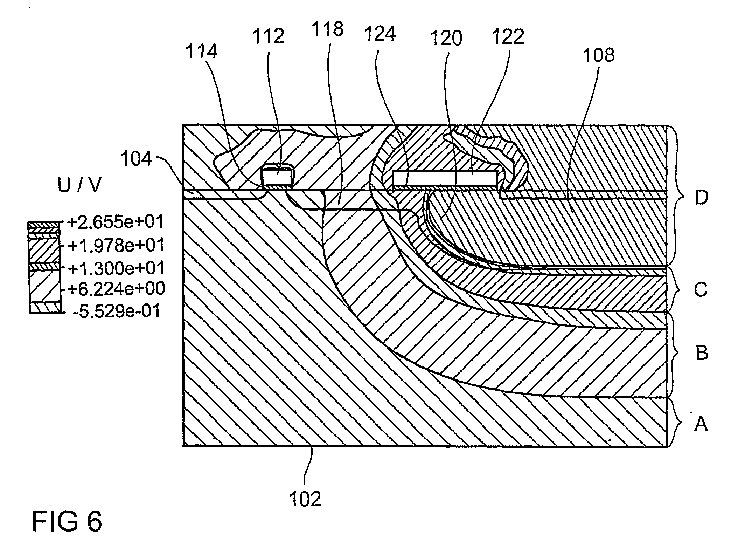

In Fig. 6 ist schematisch die Spannungsverteilung zwischen dem Gatebereich und dem Drainbereich des LDMOS-Transistors aus Fig. 4 mit einer Dotierungsverteilung gemäß Fig. 5 gezeigt. An dem LDMOS-Transistor liegt eine Drainspannung U_{Drain} von 26 V und eine Gatespannung U_{Gate} von 16 V an. Im Bereich A, also innerhalb des Substrats und unterhalb des Gatebereichs (dem Kanalbereich 116) und in einem Teil des Abschnitts 118 liegt die Spannung bei etwa -0,55 V. Im Bereich B, der sich ausgehend von einem Abschnitt unterhalb des Drainbereichs 108 in den Bereich 118 erstreckt, liegt die Spannung in einem Bereich von etwa 6 V bis 13 V. Im Bereich C, der sich ausgehend von einem Abschnitt unterhalb des Drainbereichs 108 in einem Grenzbereich zwischen dem Bereich 118 und Zwischenbereich 120 und um die Feldplatte 122 herum erstreckt, liegt die Spannung im Bereich von etwa 13 V bis etwa 20 V. Im Bereich C, der sich unter dem Drainbereich 108 bis in den Zwischenbereich 120 unter die Feldplatte 122 erstreckt und oberhalb des Drainbereichs in einem Bereich außerhalb der Feldplatte erstreckt liegt die Spannung zwischen 20 V und 26 V.

Bei dem anhand der Fig. 4 bis 6 dargestellten Ausführungsbeispiel erfolgt ähnlich wie im Stand der Technik eine zusätzliche Implantation 120 zwischen dem Abschnitt 118 und dem Drainbereich 108, wobei, wie erwähnt, die Dotierungskonzentration der zusätzlichen Implantation zwischen der Dotierungskonzentration des Abschnitts 118 und des Drainbereichs liegt. Zusätzlich wird gemäß dem bevorzugten Ausführungsbeispiel eine Struktur aus leitfähigem Material ausgebildet, nämlich die Feldplatte 122, die über dem Zwischenbereich 120 angeordnet ist. Die Feldplatte kann mit einer elektrischen Spannung beaufschlagt werden, und bei geeigneter Wahl der Lage der Feldplatte und der elektrischen Spannung bewirkt diese eine Veränderung der elektrischen Feldlinien, so dass der Spannungsgradient reduziert und damit die Stoßionisation verringert wird. Aus einem Vergleich der Fig. 10, die eine Anordnung ohne Feldplatte zeigt, und der Fig. 6, die eine Anordnung mit Feldplatte zeigt, ist das Zurückdrängen der Potentiallinien durch die Feldplatte 122 zu erkennen.

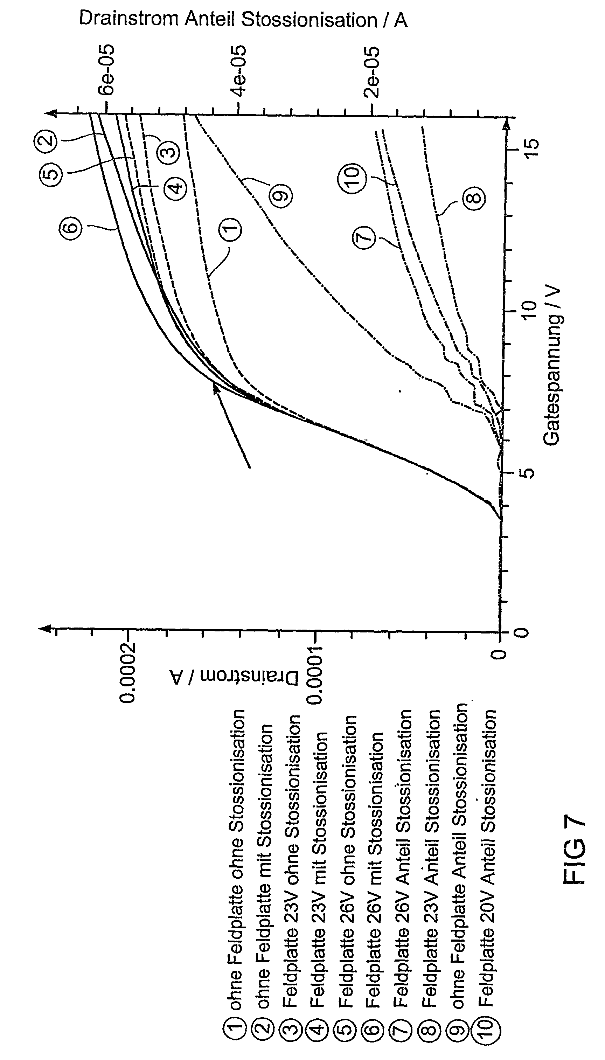

In Fig. 7 ist ein Graph dargestellt, der den Verlauf des Drainstroms über der Gatespannung darstellt, die über die x-Achse aufgezeichnet ist. Die linke y-Achse bezeichnet den fließenden Drainstrom und die rechte y-Achse bezeichnet den Anteil des Stromes am Drainstrom, der von einer Stoßionisation her rührt. Es sind 10 Kurven in Fig. 7 aufgezeichnet, die den Drainstrom und den anteiligen Strom aufgrund der Stoßionisation für Anordnungen ohne Feldplatte und für Anordnungen mit einer Feldplatte die mit unterschiedlichen Spannungen beaufschlagt ist, wiedergeben. Die Kurven 1 bis 6 geben den Verlauf des Drainstroms wieder (in Fig. 7 auf der linken y-Achse aufgetragen). Die Kurven 7 bis 10 geben den Verlauf des Anteils des von der Stoßionisation stammenden Drainstroms wieder (in Fig. 7 auf der rechten y-Achse aufgetragen).

Die Kurve 1 zeigt den Verlauf des Drainstroms über der Gatespannung für eine Anordnung, wie sie beispielsweise anhand der Fig. 9 dargelegt ist, also eine Anordnung ohne Feldplatte. Die Kurve 1 zeigt den Verlauf des Drainstroms unter der Annahme, dass keine Stoßionisation stattfindet. Die Kurve 2 zeigt den Verlauf des Drainstroms über der Gatespannung unter der Annahme dass eine Stoßionisation vorliegt. Wie zu erkennen ist, ist der Drainstrom verglichen mit Kurve 1 deutlich erhöht. Die Kurve 9 zeigt den Anteil des Stromes der bei einer solchen Anordnung aufgrund der Stoßionisation erzeugt wird. Wie zu erkennen ist, steigt der Verlauf der Kurve 9 beginnend bei etwa 7 V Gatespannung fast linear an und erreicht bei etwa 15 V Gatespannung einen Wert von etwa 4,7 x 10⁻⁵ A.

Der Kurvenverlauf 3 und der Kurvenverlauf 5 geben den Verlauf des Drainstroms über der Gatespannung für eine Anordnung wieder, die in Fig. 4 dargestellt ist, unter der Annahme, dass keine Stoßionisation auftritt, wobei in diesem Fall an der Feldplatte eine Spannung von 23 V bzw. von 26 V anliegt. Die Kurven 4 und 6 zeigen den Verlauf einer solchen Anordnung bei Anlegen einer Spannung von 23 V bzw. 26 V an die Feldplatte unter der Annahme dass eine Stoßionisation stattfindet. Wie aus dem Verlauf der Kurven zu entnehmen ist, ergibt sich aufgrund der Stoßionisation ein erhöhter Strom verglichen mit dem Fall ohne Stoßionisation, welcher aufgrund des durch die Stoßionisation erzeugten zusätzlichen Stromes hervorgerufen wird. Die Kurven 7 und 8 stellen den Anteil des Stromes am Gesamtdrainstrom dar, der aufgrund der Stoßionisation erzeugt wird, und wie zu erkennen ist, steigen die Kurven 7 und 8 verglichen mit der Kurve 9 flacher an und erreichen einen niedrigeren Endwert, so dass der Anteil des Stoßionisationsstromes bei Verwendung der Feldplatte und Beaufschlagen derselben mit unterschiedlichen Spannungen gegenüber der Anordnung ohne Feldplatte (siehe Kurve 9) deutlich reduziert ist. Die Kurve 10 bezeichnet den Anteil der Stoßionisation wenn an die Feldplatte ein Spannungswert von 20 V angelegt wird.

Wie aus dem Graph von Fig. 7 zu entnehmen ist, bewirkt die Stoßionisation eine Erhöhung des Drainstroms, insbesondere im oberen Kennlinienbereich. Die Differenz der beiden Kurven ist auf der rechten y-Achse aufgetreten. Aus Fig. 7 sind deutlich die Vorteile des Transistors mit Feldplatte zu erkennen. Ein Vorteil besteht darin, dass die Stoßionisation aufgrund der Feldplatte reduziert wird. Ferner ergibt sich verglichen mit den Kurven 1 und 2 eine Erhöhung des maximalen Stroms im oberen Kennlinienbereich (Kurve 6). Ein weiterer Vorteil besteht darin, dass die Kennlinie erst bei höheren Gatespannungen abknickt, wie durch den Pfeil in Fig. 7 dargestellt ist.

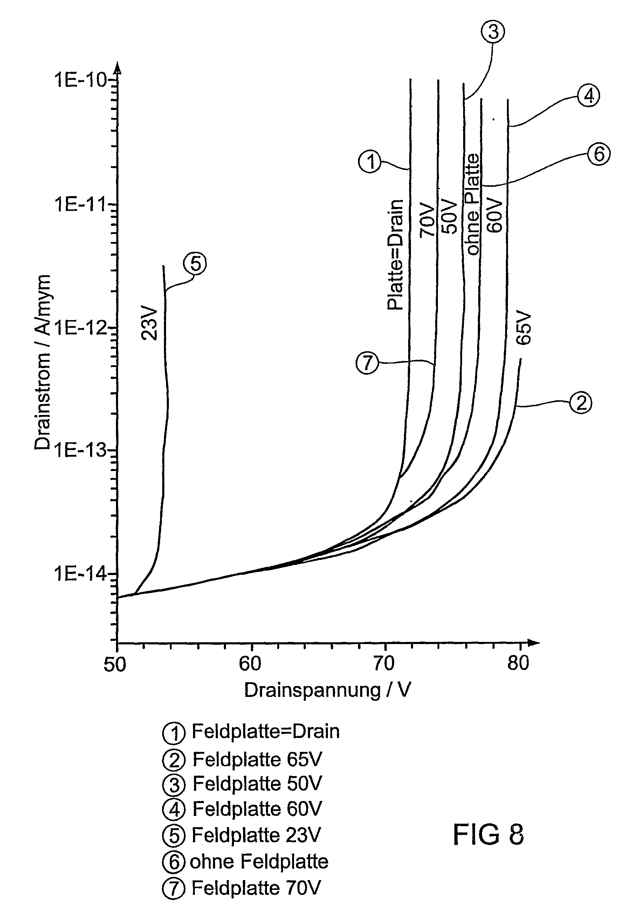

Ein weiterer Vorteil der Verwendung der erfindungsgemäßen Feldplatte wird nachfolgend anhand der Fig. 8 erläutert, die einen Graphen darstellt, der die Veränderung der Durchbruchspannung bei Verwendung der Feldplatte verdeutlicht. Es wird, von einer Struktur ausgegangen, die anhand der Fig. 4 beschrieben wurde. Die Kurve 1 zeigt den Verlauf des Drainstroms über der Drainspannung wenn die Feldplatte mit dem Drainanschluss verbunden ist, also an der Feldplatte 122 die Drainspannung anliegt. Die Kurven 2, 3, 4 und 5 zeigen Kurvenverläufe für Spannungen von 65 V, 50 V, 60 V bzw. 23 V an der Feldplatte. Die Kurve 6 zeigt den Verlauf des Drainstroms wenn keine Feldplatte vorgesehen ist, also bei einer Ausführungsform wie sie anhand der Fig. 9 beschrieben wurde. Die Kurve 7 bezeichnet den Verlauf des Drainstroms über der Drainspannung wenn an der Feldplatte eine Spannung von 70 V anliegt.

Wie aus der Fig. 8 zu erkennen ist, besteht ein weiterer Vorteil der vorliegenden Erfindung darin, dass durch die Verwendung der Feldplatte und des Beaufschlagen derselben mit einer geeigneten Spannung das Durchbruchverhalten des Transistors gesteuert werden kann. Wie zu erkennen ist, lässt sich abhängig von dem an die Feldplatte angelegten Spannungswert die Durchbruchspannung gegenüber einer Transistoranordnung ohne Feldplatte in einem weiten Bereich verschieben. Wählt man als Spannung 60 oder 65 V so erhöht sich die Durchbruchspannung, wohingegen beim Anlegen von 70 V, 50 V oder 23 V eine Verschiebung der Drainspannung, verglichen mit einer Anordnung ohne Platte, nach unten erfolgt. Gleiches gilt wenn die Feldplatte eine Spannung aufweist, die der Drainspannung entspricht.

Wie oben erwähnt wurde, sind zwei Ausführungsbeispiele der Feldplatte möglich, wobei bei einem Ausführungsbeispiel die Feldplatte z. B. durch eine externe Schaltung mit einer vorbestimmten Spannung beaufschlagbar ist. Im zweiten Ausführungsbeispiel ist die Feldplatte "floatend", also mit keinem definierten Potential beaufschlagt. Die Feldplatte kann ferner entweder direkt auf dem Substrat aufgebracht sein oder zwischen der Feldplatte und dem Substrat kann eine isolierende Zwischenschicht z. B. aus einem Oxid, vorgesehen sein.

Erfindungsgemäß kann für die Beaufschlagung der Feldplatte mit einer Spannung eine entsprechende Schaltung vorgesehen sein, die eine an der Halbleiterstruktur anliegende Drainspannung empfängt und abhängig von der empfangenen Drainspannung die an die Feldplatte angelegte Spannung auf einen optimalen Wert einstellen. Der optimale Wert wird durch eine Messung der Transistorkennlinien bei verschiedenen Spannungen an der Feldplatte bestimmt. Optimale Werte für eine Spannung an der Feldplatte sind solche, bei denen die oben beschriebenen Vorteile, z.B. niedrige Stoßionisation, hohe Durchbruchspannung, erreicht werden, und z.B. die Stoßionisation und die Durchbruchspannung optimale Werte annehmen.

Gemäß einem weiteren Ausführungsbeispiel ist die Schaltung derart ausgebildet, dass die an die Feldplatte angelegte Spannung auf einen konstanten Anteil der Drainspannung gehalten wird. Dies ist eine einfache Näherung der optimalen Werte. Die Spannung kann z.B. durch einen einfachen Spannungsteiler aus der Drainspannung erzeugt werden.

Bei einem wiederum anderen Beispiel ist die Schaltung derart ausgelegt, dass die Spannung an der Feldplatte der Drainspannung entspricht. Dies ist eine Vereinfachung und ist mit geringst möglichem Aufwand zu implementieren. Der Vorteil der einfachen Implementierung überwiegt das in diesem Fall nicht ganz optimale Verhalten (Performance) des Transistors.

Wie oben ausgeführt, kann die Feldplatte entweder durch ein Oxid von dem Substrat getrennt sein oder sie ist direkt auf dem Substrat angeordnet und bildet einen hochohmigen Kontakt oder eine Schottky-Diode.

Obwohl die obige Beschreibung der bevorzugten Ausführungsbeispiele anhand eines p-Siliziumsubstrats erfolgt ist, ist offensichtlich dass anstelle des beschriebenen n-Kanal LDMOS-Transistors auch ein p-Kanal LDMOS-Transistor mit der erfindungsgemäße Feldplatte versehen sein kann, und ferner ist die vorliegende Erfindung nicht auf das Material Silizium beschränkt, sondern auch andere Materialien zur Herstellung von Transistoren sind möglich, wie beispielsweise GaAs.

Anstelle der in Fig. 2 und 3 bzw. 4 bis 8 bezeichneten Anordnungen sind die erfindungsgemäßen Vorteile der Reduzierung der Stoßionisation auch dann zu erreichen, wenn auf den Zwischenbereich 120 verzichtet wird und die Feldplatte ausschließlich über dem Übergang zwischen der LDD und dem Drainbereich angeordnet wird, wie dies in Fig. 1 gezeigt ist.

Ferner ist darauf hinzuweisen, dass anstelle der gezeigten Abmessungen der Feldplatte diese auch so ausgestaltet sein kann, dass sich diese im wesentlichen über den Zwischenabschnitt erstreckt und gegebenenfalls auch in den ersten Drainabschnitt hinein erstreckt.

Gemäß einem bevorzugten Ausführungsbeispiel ist die Feldplatte aus Polysilizium hergestellt und hat eine Dicke von 0,3 µm bis 1,5 µm.

### Bezugszeichenliste

- 100: Halbleiter-Struktur
- 102: Substrat
- 104: Sourcebereich
- 106: Sourcekontakt
- 108: Drainbereich
- 110: Drainkontakt
- 112: Gateoxid
- 114: Gatekontakt
- 116: Kanalbereich
- 118: lateral diffundierter Drainbereich
- 120: Zwischenbereich
- 122: Feldplatte
- 124: isolierende Schicht
- S: Sourceanschluß
- D: Drainanschluß
- G: Gateanschluß
- F: Feldplattenanschluß
- A: erster Bereich
- B: zweiter Bereich
- C: dritter Bereich
- D: vierter Bereich

## Patentansprüche

1. Halbleiter-Struktur, mit
einem Substrat (102);
einem Sourcebereich (104), der in dem Substrat (102) gebildet ist;
einem Drainbereich, der in dem Substrat (102) gebildet ist, wobei der Drainbereich einen ersten Drainabschnitt (108) mit einer ersten Dotierungskonzentration und einen zweiten Drainabschnitt (118) mit einer zweiten Dotierungskonzentration aufweist, die niedriger ist als die erste Dotierungskonzentration;
einem Drainkontakt (110), der mit dem ersten Drainabschnitt (108) in Kontakt ist;
einem Kanalbereich (116) zwischen dem Sourcebereich (104) und dem zweiten Drainabschnitt (118), wobei der Kanalbereich (116) an den Sourcebereich (104) und an den zweiten Drainabschnitt (118) angrenzt;
einem Gate (112,114) oberhalb des Kanalbereichs; und
einer leitfähigen Feldplatte (122), die lateral von dem Übergang zwischen dem Kanalbereich (116) und dem zweiten Drainabschnitt (118) beabstandet ist und über dem Übergang zwischen dem ersten Drainabschnitt (108) und dem zweiten Drainabschnitt (118) angeordnet ist, um einen Gradienten des elektrischen Feldes an dem Übergang zu reduzieren, wobei die Feldplatte beabstandet von dem Gate (112,114) und dem Drainkontakt (110) angeordnet ist.

2. Halbleiter-Struktur nach Anspruch 1, bei der eine isolierende Schicht (124) auf dem Substrat (102) angeordnet ist, auf der die Feldplatte (122) angeordnet ist.

3. Halbleiter-Struktur nach Anspruch 1, bei der die Feldplatte (122) auf dem Substrat (102) angeordnet ist.

4. Halbleiter-Struktur nach einem der Ansprüche 1 bis 3, bei der die Feldplatte (122) mit einer Spannung beaufschlagbar ist.

5. Halbleiter-Struktur nach einem der Ansprüche 1 bis 4, bei der der erste Drainabschnitt (108) einen Zwischenbereich (120) mit einer dritten Dotierungskonzentration aufweist, die höher als die zweite Dotierungskonzentration und die niedriger ist als die erste Dotierungskonzentration, wobei der Zwischenbereich (120) benachbart zu dem zweiten Drainabschnitt (118) angeordnet ist.

6. Halbleiter-Struktur nach Anspruch 5, bei der die erste Dotierungskonzentration im Bereich von 1 x 10²⁰ Atomen/cm³ liegt, die zweite Dotierungskonzentration im Bereich von 1 x 10¹⁷ Atomen/cm³ liegt, und die dritte Dotierungskonzentration im Bereich von 1 x 10¹⁷ bis 2 x 10²⁰ Atomen/cm³ liegt.

7. Halbleiter-Struktur nach Anspruch 4 oder 5, bei der sich die Feldplatte (122) über den Zwischenbereich (120) erstreckt.

8. Halbleiter-Struktur nach einem der Ansprüche 1 bis 7, bei der die Feldplatte (122) aus Polysilizium hergestellt ist.

9. Halbleiter-Struktur nach einem der Ansprüche 1 bis 8, bei der die Feldplatte (122) eine Dicke von 0,3 µm bis 1,5 µm hat.

## Claims

1. Semiconductor structure comprising
a substrate (102);
a source region (104) formed in the substrate (102);
a drain region formed in the substrate (102), the drain region having a first drain portion (108) with a first doping concentration and a second drain portion (118) with a second doping concentration which is lower than the first doping concentration;
a drain contact (110) in contact with the first drain portion (108);
a channel region (116) between the source region (104) and the second drain portion (118), the channel region (116) bordering on the source region (104) and on the second drain portion (118);
a gate (112, 114) above the channel region; and
a conductive field plate (122) laterally spaced apart from the junction between the channel region (116) and the second drain portion (118) and disposed across the junction between the first drain portion (108) and the second drain portion (118) to reduce a gradient of the electric field at the junction, the field plate being disposed at a distance from the gate (112, 114) and the drain contact (110).

2. Semiconductor structure according to claim 1, wherein an isolating layer (124) is disposed on the substrate (102), whereon the field plate (122) is disposed.

3. Semiconductor structure according to claim 1, wherein the field plate (122) is disposed on the substrate (102).

4. Semiconductor structure according to one of claims 1 to 3, wherein a voltage can be applied to the field plate (122).

5. Semiconductor structure according to one of claims 1 to 4, wherein the first drain portion (108) has an intermediate region (120) with a third doping concentration which is larger than the second doping concentration and lower than the first doping concentration, wherein the intermediate region (120) is disposed adjacent to the second drain portion (118) .

6. Semiconductor structure according to claim 5, wherein the first doping concentration lies in the range of 1 x 10²⁰ atoms/cm³, the second doping concentration lies in the range of 1 x 10¹⁷ atoms/cm³, and the third doping concentration lies in the range of 1 x 10¹⁷ to 2 x 10²⁰ atoms/cm³.

7. Semiconductor structure according to claim 4 or 5, wherein the field plate (122) extends across the intermediate region (120).

8. Semiconductor structure according to one of claims 1 to 7, wherein the field plate (122) is made of polysilicon.

9. Semiconductor structure according to one of claims 1 to 8, wherein the field plate (122) has a thickness of 0.3 µm to 1.5 µm.

## Revendications

1. Structure à semi-conducteur comprenant
un substrat (102);
une zone (104) de source, qui est formée dans le substrat (102);
une zone de drain, qui est formée dans le substrat (102), la zone de drain comprenant une première partie (108) de drain ayant une première concentration de dopage et une deuxième partie (118) de drain ayant une deuxième concentration de dopage, qui est plus petite que la première concentration de dopage;
un contact (110) de drain, qui est en contact avec la première partie (108) de drain;
une zone (116) de canal entre la zone (104) de source et la deuxième partie (118) de drain, la zone (116) de canal étant voisine de la zone (104) de source et de la deuxième partie (118) de drain;
une grille (112, 114) au-dessus de la zone de canal; et
une plaque (122) de champ conductrice, qui est à distance latéralement de la transition entre la zone (116) de canal et la deuxième partie (118) de drain, et qui est disposée au-dessus de la transition entre la première partie (108) de drain et la deuxième partie (118) de drain pour réduire un gradient du champ électrique à la transition, la plaque de champ étant à distance de la grille (112, 114) et du contact (110) de drain.

2. Structure à semi-conducteur suivant la revendication 1, dans laquelle il est disposée sur le substrat (102), une couche (124) isolante sur laquelle est placée la plaque (122) de champ.

3. Structure à semi-conducteur suivant la revendication 1, dans laquelle la plaque (122) de champ est disposée sur le substrat (102).

4. Structure à semi-conducteur suivant l'une des revendications 1 à 3, dans laquelle il peut être appliqué une tension à la plaque (122) de champ.

5. Structure à semi-conducteur suivant l'une des revendications 1 à 4, dans laquelle la première partie (108) de drain comprend une partie (120) intermédiaire ayant une troisième concentration de dopage, qui est plus grande que la deuxième concentration de dopage et qui est plus petite que la première concentration de dopage, la partie (120) intermédiaire étant voisine de la deuxième partie (118) de drain.

6. Structure à semi-conducteur suivant la revendication 5, dans laquelle la première concentration de dopage est de l'ordre de 1 x 10²⁰ atomes/cm³, la deuxième concentration de dopage est de l'ordre de 1 x 10¹⁷ atomes/cm³, et la troisième concentration de dopage est de l'ordre de 1 x 10¹⁷ à 2 x 10²⁰ atomes/cm³.

7. Structure à semi-conducteur suivant la revendication 4 ou 5, dans laquelle la plaque (122) de champ s'étend au-dessus de la partie (120) intermédiaire.

8. Structure à semi-conducteur suivant l'une des revendications 1 à 7, dans laquelle la plaque (122) de champ est en polysilicium.

9. Structure à semi-conducteur suivant l'une des revendications 1 à 8, dans laquelle la plaque (122) de champ a une épaisseur de 0,3 µm à 1,5 µm.
